# EUROPÄISCHE PATENTSCHRIFT

(11) **EP 0 919 867 B1**
(45) Veröffentlichungstag und Bekanntmachung des Hinweises auf die Patenterteilung: **21.05.2003**
(21) Anmeldenummer: 98121532.0
(22) Anmeldetag: 17.11.1998
(51) Int. Cl.: G03F 7/004, G03F 7/039

(54) **Chemisch verstärkter Resist für die Elektronenstrahllithographie**
Chemically amplified resist for electron beam lithography
Photoréserve chimiquement amplifiée pour la lithographie par faisceau d'électrons

(30) Priorität: 28.11.1997 DE 19752941
(43) Veröffentlichungstag der Anmeldung: 02.06.1999
(73) Patentinhaber: Infineon Technologies AG, 81669 München (DE)
(72) Erfinder: Elian, Klaus Dr., 91058 Erlangen (DE); Günther, Ewald Dr., 91074 Herzogenaurach (DE); Leuschner, Rainer Dr., 91091 Grossenseebach (DE)
(74) Vertreter: Müller - Hoffmann & Partner

(56) Entgegenhaltungen:
- EP-A- 0 440 375
- EP-A- 0 701 171
- EP-A- 0 708 368
- EP-A- 0 742 488
- EP-A- 0 848 288
- EP-A- 0 874 281

## Beschreibung

Die Erfindung betrifft einen chemisch verstärkten Resist für die Elektronenstrahllithographie.

In der Mikroelektronik werden im großen Umfang sogenannte chemisch verstärkte Resists ("chemically amplified resists") für die optische Lithographie und das Elektronenstrahlschreiben ("electron-beam lithography") eingesetzt (siehe dazu: "Solid State Technology", Vol. 39 (1996), No. 7, Seiten 164 bis 173). Die chemische Verstärkung findet sowohl bei naßentwickelbaren Einlagenresists Anwendung als auch bei ganz oder teilweise trockenentwickelbaren Resists. Die Resists können dabei nach dem Prinzip der säurekatalytischen Spaltung arbeiten, wobei polare, aber blockierte chemische Gruppen, beispielsweise Carboxylgruppen oder phenolische Hydroxylgruppen, durch eine photolytisch erzeugte Säure deblockiert werden und der Resist in den belichteten Bereichen seine Polarität ändert. Diese Polaritätsänderung kann beispielsweise zur Entwicklung des Resists in einem basischen Entwickler oder - bei trockenentwickelbaren Resists - für eine selektive Silylierung genutzt werden. Beispiele für blockierende Gruppen sind tert.-Butylester- und tert.-Butoxycarbonyloxygruppen.

Aus der EP 0 492 256 B1 ist eine photolithographische Strukturerzeugung bekannt, bei der ein trockenentwickelbarer Resist nach der Belichtung einer Temperaturbehandlung (Post Exposure Bake = PEB) unterworfen, dann aus flüssiger Phase silyliert und anschließend im Sauerstoffplasma anisotrop geätzt bzw. trocken entwickelt wird. Je nach der Art der Silylierungslösung werden dabei positive oder negative Strukturen (Bilder) erzeugt. Der Resist besteht im allgemeinen mindestens aus zwei festen Bestandteilen, d.h. aus einem Basispolymer und einem photoaktiven Säurebildner. Das Basispolymer enthält Carbonsäureanhydrid- und tert.-Butylester-Partialstrukturen, der Säurebildner ist vorzugsweise eine Oniumverbindung, wie Diphenyliodonium- und Triphenylsulfonium-trifluormethansulfonat. Ein derartiger Resist eignet sich insbesondere für die Photostrukturierung im Submikron- und Subhalbmikronbereich mit sehr steilen Flanken.

Bei einer Strukturerzeugung in der vorstehend geschilderten Weise wurde - ebenso wie bei anderen Resistsystemen, welche nach dem Prinzip der säurekatalytischen Spaltung arbeiten - der sogenannte Standzeit-Effekt ("delay time effect") festgestellt. Dieser Effekt äußert sich, beispielsweise beim Elektronenstrahlschreiben, in einer Abweichung der gewünschten Strukturdimension von der nach der Entwicklung tatsächlich erhaltenen Struktur, wenn zwischen dem Elektronenstrahlschreiben und der Temperaturbehandlung (PEB) Wartezeiten auftreten (Post Exposure Delay = PED). Je länger diese Wartezeit ist, um so größer sind die Strukturabweichungen. Bei anhydridgruppenhaltigen Resists der vorstehend genannten Art beispielsweise beträgt die tolerable Zeitspanne ca. 5 bis 10 min. Eine derartig kurze Zeitspanne ist aus produktionstechnischen Gründen jedoch nicht akzeptabel.

Die geschilderte Standzeitproblematik ist allgemein bekannt und wird auf basische Kontaminationen in der Luft zurückgeführt, die während der Standzeit die photochemisch erzeugte starke Säure desaktivieren. Deshalb wurde bereits vorgeschlagen, dieses Problem durch Filtration der Luft mittels Aktivkohle zu lösen (siehe: "Proceedings SPIE", Vol. 1466 (1991), Seiten 2 bis 12). Dies erfordert aber hohe Investitionen.

Auch durch andere Maßnahmen kann der Standzeit-Effekt nicht entscheidend beeinflußt werden:
- Durch den Zusatz von organischen Aminen zum Resist, unter Verwendung von Triphenylsulfonium-trifluormethansulfonat als empfindlichen Photosäurebildner (Photo Acid Generator = PAG), kann der Resist zwar gegen laterale Säurediffusionsvorgänge stabilisiert werden, allerdings lassen sich dabei - bedingt durch den Basenzusatz - keine hochempfindlichen Resists realisieren ("Journal of Photopolymer Science and Technology", Vol. 9 (1996), No. 4, Seiten 677 bis 684).
- Durch die Verwendung von Photosäurebildnern mit sterisch kleinen Resten starker Säuren, beispielsweise Trifluormethansulfonatresten, kann zwar die benötigte Belichtungsempfindlichkeit erreicht werden, die Photosäurebildner können im festen Resist allerdings sehr leicht diffundieren und sind - aufgrund der hohen Säurestärke - gegenüber basischen Einflüssen sehr standzeitempfindlich ("Journal of Vacuum Science & Technology B", Vol. 12 (1994), No. 6, Seiten 3857 bis 3862).
- Durch die Zugabe von als tert.-Butylester geschützten Monooder Dicarbonsäuren, in Form von Monomeren oder kurzkettigen Polymeren, zum Resist werden weitere Lösungsinhibitoren eingebracht und dadurch Systeme mit hoher Empfindlichkeit erhalten. Hierbei lassen sich aber lediglich Strukturdimensionen von 0,5 µm realisieren ("Chemistry of Materials", Vol. 8 (1996), No. 2, Seiten 376 bis 381).

Das Standzeitverhalten von Resists kann im Prinzip zwar durch die Wahl eines geeigneten Photosäurebildners, Diphenyliodonium-tosylat anstelle des entsprechenden -trifluormethansulfonats, verbessert werden, hierbei nimmt dann aber die Empfindlichkeit ab ("MNE '94 - International Conference on Micro- and Nano-Engineering 94", Davos/CH, 26.-29.9.1994, Beitrag: P23). Dadurch sind beim Elektronenstrahlschreiben aber längere Schreibzeiten erforderlich, was in der Produktion unerwünscht ist.

In der EP 0 742 488 A2 wird ein positiv arbeitender Photoresist beschrieben, welcher ein Sulfonat einer N-Hydroxyimidverbindung als Säurebildner enthält. Für die Belichtung wird ein Excimer-Laser verwendet, welcher sehr kurzwelliges Licht emittiert.

In der EP 0 701 171 A1 wird eine Resistzusammensetzung beschrieben, welche neben einem alkalilöslichen Polymer einen Lösungsinhibitor sowie einen Photosäurebildner umfaßt. Der Photoresist eignet sich für eine Belichtung mit Licht sehr kurzer Wellenlänge, wie es beispielsweise von einem KrF-Excimer-Laser emittiert wird.

In der EP 0 400 375 A1 werden spezielle Diazodisulfone beschrieben, welche als Photosäurebildner in einem Photoresist verwendet werden können. Die Freisetzung der Säure erfolgt durch Bestrahlung mit Licht sehr kurzer Wellenlänge, wie sie beispielsweise von einem KrF-Excimer-Laser emittiert wird.

In der EP 0 708 368 A1 wird ein positiv arbeitender Photoresist beschrieben. Für die Belichtung wird wiederum kurzwelliges Licht verwendet, wie es von einem KrF-Excimer-Laser emittiert wird. Der Photoresist umfaßt ein alkalilösliches Polymer, einen Photosäurebildner sowie einen niedermolekularen Lösungsinhibitor, der säurelabile Gruppen umfaßt, die nach Ihrer Abspaltung die Löslichkeit des Inhibitors in einer alkalischen Entwicklerlösung erhöhen. Ferner umfaßt der Photoresist ein Polymer, das basische Stickstoffatome aufweist.

In der EP 0 874 281 A1 wird ein chemisch verstärkter Resist beschrieben, der ein Polymer mit säurelabilen Gruppen umfaßt, eine photoreaktive Verbindung, die bei Belichtung oder Elektronenbestrahlung eine Sulfonsäure freisetzt, eine Verbindung, die mit der Sulfonsäure eine reversible chemische Reaktion eingehen kann, und ein Lösemittel. Der Photoresist kann ferner einen Sensibilisator enthalten, der eine Erhöhung der Licht- bzw. Elektronenausbeute bewirkt. Durch die Pufferverbindnung wird die bei der Belichtung bzw. Bestrahlung gebildete Sulfonsäure in einer reversiblen chemischen Reaktion abgefangen. Diffundieren aus der Umgebungsluft Basen in den Photoresist ein, werden Photonen abgegeben, sodaß die Basen neutralisiert werden.

In der EP 0 848 288 A1 wird ein Resistmaterial beschrieben, welches ein Polymer mit säurelabilen Gruppen umfaßt, die über eine acetalische oder ketalische Bindung an das Polymer gebunden sind. Ferner umfaßt der Resist einen Photosäurebildner. der bei Bestrahlung eine Säure mit einem pKₐ von weniger als 2 freisetzt. Zur Unterdrückung von Standzeiteffekten werden verschiedene Sulfonate als Photosäurebildner vorgeschlagen.

Aufgabe der Erfindung ist es, einen chemisch verstärkten, für die Elektronenstrahllithographie geeigneten Resist anzugeben, der ein - im Vergleich zu bekannten Resists - verbessertes Standzeitverhalten zeigt und gleichzeitig eine Belichtungsempfindlichkeit < 10 µC/cm², insbesondere ≤ 1 µC/cm², bei hoher Auflösung, insbesondere bei einem Auflösungsvermögen ≤ 0,25 µm, aufweist.

Dies wird erfindungsgemäß dadurch erreicht, daß der Resist folgende Komponenten enthält:
- ein Polymer mit säurekatalysiert spaltbaren, lösungsinhibierenden Gruppen,
- eine photoreaktive Verbindung, die bei Elektronenbestrahlung eine Sulfonsäure mit einem pKₐ-Wert ≤ 2,5 freisetzt (Photosäurebildner),
- einen elektronenstrahlempfindlichen Sensibilisator und
- ein Lösemittel.

Der chemisch verstärkte Resist nach der Erfindung ist ein produktionstauglicher trockenentwickelbarer Positivresist. Das der Erfindung zugrunde liegende Problem wird dabei durch folgende Maßnahmen gelöst.

Der Resist, beispielsweise auf der Basis von Methacrylsäuretert.-butylester/Maleinsäureanhydrid (als Polymer), weist einen Photosäurebildner in Form einer photoaktiven Verbindung auf, aus der bei der Elektronenbestrahlung eine relativ schwache Sulfonsäure (pKₐ ≤ 2,5) freigesetzt wird; der pKₐ-Wert ist der sogenannte Säureexponent (negativer dekadischer Logarithmus der Säurekonstante Kₐ). Derartige Säuren sind beispielsweise Benzolsulfonsäure (pKₐ = 0,70) und Toluolsulfonsäure (pKₐ = 1,55). Die relativ schwache Sulfonsäure hat den Vorteil, daß sie gegenüber basischen Verunreinigungen relativ unempfindlich ist, und daß der Dampfdruck und die Beweglichkeit deutlich geringer sind als bei der sonst häufig eingesetzten Trifluormethansulfonsäure mit einem pKₐ-Wert von -5,9 (siehe dazu: "Japanese Journal of Applied Physics", Vol. 34 (1995), Pt. 1, No. 8A, Seiten 4247 bis 4252).

Als Photosäurebildner, der vorzugsweise einen pKₐ-Wert ≥ -1 aufweist, werden vorteilhaft folgende photoaktive Verbindungen eingesetzt: Diphenyliodoniumsalze und Triphenylsulfoniumsalze (von Sulfonsäuren) sowie Bis-benzolsulfone und N-Sulfonyloxy-maleinimide, -phthalimide und -naphthalimide, d.h. Ester von Sulfonsäuren mit Hydroxyimiden. Die dem Photosäurebildner zugrunde liegenden Sulfonsäuren können sowohl aromatischer Natur (wie Benzol- und Toluolsulfonsäure) als auch aliphatischer Natur (wie Propan- und Cyclohexansulfonsäure) sein. Die N-Sulfonyloxy-maleinimide können auch in das Polymer eingebaut sein, wodurch einer möglichen Entmischung von Polymer und Photosäurebildner vorgebeugt wird. Als Photosäurebildner können ferner beispielsweise auch Diazodisulfone verwendet werden. Weisen die Photosäurebildner aromatische Partialstrukturen auf, so können durch eine Variation von Substituenten an den Aromaten die Säurestärke und die Polarität sowie sterische Effekte gezielt eingestellt werden. Derartige Verbindungen sind beispielsweise die Ester von N-Hydroxyphthalimid mit p-Toluolsulfonsäure, p-Fluorbenzolsulfonsäure und p-Iodbenzolsulfonsäure.

Durch die schwache Sulfonsäure wird das Standzeitverhalten des Resists nach der Erfindung entscheidend verbessert. Um eine hohe Empfindlichkeit zu erreichen, enthält dieser Resist - neben der die Sulfonsäure generierenden photoaktiven Verbindung - noch einen elektronenstrahlempfindlichen Sensibilisator. Dieser Sensibilisator absorbiert einen Teil der Energie der Elektronenstrahlung und gibt die absorbierte Energie anschließend an den Photosäurebildner weiter. Dieser Effekt, der bislang nur von Belichtungen im UV-Bereich bekannt war, konnte - gemäß der Erfindung - erstmals auch bei der Elektronenstrahllithographie realisiert werden. Dem Effekt liegt vermutlich ein kombinierter Elektronen/Protonen-Übertragungsmechanismus vom Sensibilisator zum Photosäurebildner zugrunde.

Durch den Sensibilisierungsprozeß wird die effektive Quantenausbeute der Spaltung des Photosäurebildners erhöht. Dadurch wird - bei gleicher Elektroneneinstrahlungsdosis (= Schreibzeit) und gleichem Ausgangsgehalt des Resists an Photosäurebildner - mehr saurer Katalysator für die Abspaltung der lösungsinhibierenden Gruppen des Polymers gebildet. Auf diese Weise steigt die Belichtungsempfindlichkeit des Resists, ohne daß die eigentliche Katalysatorstärke erhöht werden muß, wodurch dann auch die Standzeitempfindlichkeit des Resists erhöht würde. Im Vergleich zu einem unsensibilisierten Resistsystem hat ein sensibilisiertes System eine bis zum Faktor 6 höhere Belichtungsempfindlichkeit, abhängig von der Resistzusammensetzung.

Durch die vorstehend beschriebene neue Möglichkeit der Sensibilisierung können nunmehr auch für die Elektronenstrahllithographie alle bislang nur von der optischen Lithographie bekannten Vorteile von Sensibilisierungsmechanismen genutzt werden. Dazu gehört vor allem eine geringere Abhängigkeit der Belichtungsempfindlichkeit von der Wahl des Photosäurebildners. Dadurch ist es nunmehr möglich, zunächst - ohne Beachtung der geforderten Belichtungsempfindlichkeit - einen unter dem Gesichtspunkt des Standzeitverhaltens geeigneten Photosäurebildner auszuwählen. Die Einstellung der geforderten Belichtungsempfindlichkeit erfolgt dann danach durch Zusatz variabler Mengen an Sensibilisator. Durch den Sensibilisator ergeben sich somit mehr Möglichkeiten bei der Auswahl von geeigneten Photosäurebildnern. Das Masseverhältnis von Photosäurebildner zu Sensibilisator beträgt beim Resist nach der

Erfindung im allgemeinen etwa 0,5:1,5 bis 1,5:0,5; vorteilhaft beträgt dieses Verhältnis 0,5:1 bis 1,5:1 und vorzugsweise etwa 1:1.

Der elektronenstrahlempfindliche Sensibilisator ist erfindungsgemäß eine Verbindung folgender Struktur: 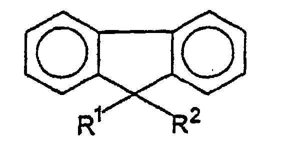 wobei folgendes gilt:
R¹ = OH oder OR,
R² = COOH oder COOR,
mit R = C₁- bis C₅-Alkyl.

Die Reste R¹ und R² dieses Sensibilisators, der ein Fluorenderivat ist, können einen gleichen oder verschiedenen Alkylrest R aufweisen, wobei der Alkylrest verzweigt oder unverzweigt sein kann. Der Rest R¹ ist vorzugsweise eine Hydroxylgruppe, der Rest R² vorzugsweise eine Carboxylgruppe. Besonders bevorzugt ist der Sensibilisator 9-Hydroxy-9-fluorencarbonsäure.

Da der Sensibilisatorzusatz nur auf den Photosäurebildner einen direkten Einfluß ausübt, nicht aber auf das Polymer, können im Resist nach der Erfindung allgemein Polymere eingesetzt werden, die säurekatalysiert spaltbare, lösungsinhibierende Gruppen aufweisen. Derartige Gruppen sind vorzugsweise tert.-Butylester- und tert.-Butoxycarbonyloxygruppen. Weitere mögliche Gruppen sind beispielsweise Tetrahydrofuranyl- und Tetrahydropyranylgruppen sowie N,O-Acetalgruppierungen in der Polymerkette. Bei den Polymeren liegt den tert.-Butylestergruppen vorzugsweise Acrylsäure-, Methacrylsäure-, Vinylbenzoesäure- oder Zimtsäure-tert.-butylester zugrunde, den tert.-Butoxycarbonyloxygruppen vorzugsweise tert.-Butoxycarbonyloxy-styrol oder -maleinimid.

Im Resist nach der Erfindung können auch Copolymere Verwendung finden. Die Copolymeren können - neben den abspaltbaren Gruppen - vorteilhaft Carbonsäureanhydridgruppen aufweisen. Dabei werden solche Polymere bevorzugt, deren Anhydridgruppen sich vom Maleinsäureanhydrid ableiten; eine andere derartige Verbindung ist beispielsweise Itaconsäureanhydrid. Geeignete Copolymere sind beispielsweise solche aus Maleinsäureanhydrid und Acrylsäure-, Methacrylsäure- oder Vinylbenzoesäure-tert.butylester. Besonders vorteilhaft erweisen sich auch Terpolymere. Dies sind beispielsweise Polymere aus Methacrylsäuretert.-butylester, Maleinsäureanhydrid und Methacrylsäure bzw. Trimethylallylsilan. Derartige Polymere können auch noch eine weitere Komponente enthalten, so daß beispielsweise ein Quaterpolymer aus Methacrylsäure-tert.-butylester, Maleinsäureanhydrid, Trimethylallylsilan und Methacrylsäureethoxyethylester Verwendung finden kann.

Als Lösemittel dienen an sich bekannte Resistlösemittel. Vorzugsweise ist das Lösemittel Methoxypropylacetat oder ein Gemisch aus γ-Butyrolacton und Cyclohexanon, insbesondere im Volumenverhältnis von etwa 1:2. Weitere geeignete Lösemittel sind beispielsweise Cyclopentanon und Cyclohexanon oder Ethylenglykol- bzw. Diethylenglykolether, gegebenenfalls im Gemisch mit Dibenzylether.

Der Resist nach der Erfindung kann sowohl in Einlagen- als auch in Zweilagenprozessen eingesetzt werden, wobei die Verwendung als Zweilagenresist bevorzugt ist. Hierbei weist der Resist im allgemeinen folgende Zusammensetzung auf: 5 bis 9 Masse-% Polymer, 0,1 bis 1 Masse-% Photosäurebildner, 0,1 bis 1 Masse-% Sensibilisator und 85 bis 94 Masse-% Lösemittel; die einzelnen Anteile ergänzen sich dabei zu 100 %. Bei der Verwendung als Einlagenresist liegt im allgemeinen folgende Zusammensetzung vor: 9 bis 18 Masse-% Polymer, 1 bis 2 Masse-% Photosäurebildner, 1 bis 2 Masse-% Sensibilisator und 78 bis 89 Masse-% Lösemittel, d.h. der Feststoffgehalt ist höher.

Bei der Verwendung des Resists nach der Erfindung als Einlagenresist erfolgt die Strukturierung in der Weise, daß auf ein Substrat eine Resistschicht aufgebracht wird. Diese Resistschicht wird getrocknet und mit Elektronen bestrahlt. Die Elektronenstrahl-exponierte Schicht wird dann für eine bestimmte Dauer einer Temperaturbehandlung (PEB) unterworfen, und danach erfolgt eine Naßentwicklung (vgl. dazu beispielsweise WO 96/08751).

Bei der Strukturerzeugung mit einem Zweilagenresist wird auf das Substrat zunächst ein Bottomresist und darauf eine Schicht des Resists nach der Erfindung als Topresist aufgebracht. Die Resistschicht wird dann getrocknet und mit Elektronen bestrahlt. Die Elektronenstrahl-exponierte Schicht wird für eine bestimmte Dauer einer Temperaturbehandlung (PEB) unterworfen und dann naß entwickelt. Anschließend wird silyliert und der Bottomresist in einem anisotropen Sauerstoffplasma trocken entwickelt (vgl. dazu beispielsweise WO 96/08751).

Die Bestrahlung erfolgt im allgemeinen mit Elektronen mit einer Beschleunigungsspannung im Bereich von 0,5 bis 100 kV. Bevorzugt wird eine Beschleunigungsspannung (beim Elektronenstrahlschreiben) im Bereich etwa zwischen 15 und 50 kV.

Die Temperaturbehandlung (PEB) erfolgt jeweils im Bereich zwischen 50 und 200°C, vorzugsweise im Bereich etwa zwischen 80 und 150°C. Die Dauer der Temperaturbehandlung beträgt im allgemeinen 5 bis 300 s, vorzugsweise etwa 15 bis 180 s.

Anhand von Ausführungsbeispielen soll die Erfindung noch näher erläutert werden (MT = Masseteil).

### Beispiel 1

Es wird ein Resist folgender Zusammensetzung verwendet: 8 MT eines Terpolymers aus Methacrylsäure-tert.-butylester, Maleinsäureanhydrid und Methacrylsäure mit einem Molgewicht von ca. 3000 g/mol (hergestellt durch radikalische Polymerisation), 1 MT des Esters von N-Hydroxyphthalimid mit p-Toluolsulfonsäure (als Photosäurebildner), 1 MT 9-Hydroxy-9-fluorencarbonsäure (als Sensibilisator) und 90 MT 1-Methoxy-2-propyl-acetat (als Lösemittel). Der Resist wird auf eine Siliziumscheibe aufgeschleudert (Umdrehungszahl: 3000 min⁻¹, Dauer: 20 s), welche mit einer 0,5 µm dicken ausgeheizten Novolakschicht (220°C/45 min im Umluftofen) als Bottomresist versehen ist; dann wird auf einer Heizplatte getrocknet (120°C/60 s). Die Schichtdicke des dabei erhaltenen Topresists beträgt etwa 250 nm. Anschließend wird der Resist mittels eines Elektronenstrahlschreibers (HL 700 / Hitachi) bei einer Beschleunigungsspannung von ca. 30 kV mit Elektronen bestrahlt und danach auf einer Heizplatte 120 s bei ca. 130°C ausgeheizt (PEB). Dabei werden, katalysiert durch die photolytisch gebildete Säure, die tert.-Butylestergruppen abgespalten. Durch Entwickeln (30 s, Puddle-Anlage / Hamatech) mit einem wäßrig-alkalischen Entwickler (NMD-W 1,19 % / Tokyo Ohka, mit einem Zusatz von 1 % Methylbenzylamin) wird die geschriebene Struktur erhalten.

Durch das Elektronenstrahlschreiben können verschiedene Bereiche direkt mit unterschiedlichen Dosen bestrahlt werden, und so kann die Dp(0)-Dosis bestimmt werden. Die auf diese Weise ermittelte Dp(0)-Dosis, nämlich < 1 µC/cm², liegt noch unter der beim Elektronenstrahlschreiber minimal möglichen Schreibdosis.

Zur Übertragung der Struktur auf das Substrat wird der Topresist - nach der Naßentwicklung - 40 s mit einer Silylierungslösung behandelt, die 2 % eines Diaminopropyl-dimethylsiloxan-oligomers, 25 % Ethanol, 70 % Isopropanol und 3 % Wasser enthält. Anschließend wird 50 s in einem Sauerstoffplasma (900 W, 30 sccm O₂) trocken geätzt.

Bei Untersuchungen hinsichtlich des Standzeitverhaltens ergibt sich, daß eine Standzeit von 24 h zwischen der Elektronenbestrahlung und der Temperaturbehandlung (PEB) eine Erhöhung der zur Durchentwicklung nötigen Strahlungsdosis lediglich um ca. 50 % erfordert.

Zum Vergleich wird ein Resist folgender Zusammensetzung untersucht, der keinen Sensibilisator enthält: 9 MT des vorstehend genannten Terpolymers, 1 MT Mono-4-tert.-butyldiphenyliodonium-2H-hexafluorpropylsulfonat (als Photosäurebildner) und 90 MT 1-Methoxy-2-propyl-acetat (als Lösemittel); die dem Photosäurebildner zugrunde liegende Hexafluorpropansulfonsäure besitzt einen dem pKₐ-Wert der Trifluormethansulfonsäure von -5,9 vergleichbaren pKₐ-Wert. Bei diesem Resist, der eine Bestrahlungsempfindlichkeit von 1,6 µC/cm² aufweist, steigt die bei einer Standzeit von 24 h (zwischen Elektronenbestrahlung und Temperaturbehandlung) erforderliche Strahlungsdosis um über 200 % an.

Aus den vergleichenden Untersuchungen ergibt sich somit folgendes: Beim Einsatz eines Photosäurebildners, dem eine relativ schwache Sulfonsäure zugrunde liegt, in Kombination mit einem speziellen Sensibilisator (auf Fluorenbasis) kann das Standzeitverhalten erheblich verbessert werden, d.h. die negativen Auswirkungen längerer Standzeiten werden deutlich reduziert.

### Beispiel 2

Es wird ein Resist folgender Zusammensetzung verwendet: 8 MT eines Terpolymers aus Methacrylsäure-tert.-butylester, Maleinsäureanhydrid und Methacrylsäure mit einem Molgewicht von ca. 3000 g/mol (hergestellt durch radikalische Polymerisation), 1 MT des Esters von N-Hydroxyphthalimid mit p-Fluorbenzolsulfonsäure (als Photosäurebildner), 1 MT 9-Hydroxy-9-fluorencarbonsäure (als Sensibilisator) und 90 MT 1-Methoxy-2-propyl-acetat (als Lösemittel). Der Resist wird auf eine Siliziumscheibe aufgeschleudert (Umdrehungszahl: 2000 min⁻¹, Dauer: 20 s), welche mit einer 1,3 µm dicken ausgeheizten Novolakschicht (220°C/45 min im Umluftofen) als Bottomresist versehen ist; dann wird auf einer Heizplatte getrocknet (120°C/60 s). Die Schichtdicke des dabei erhaltenen Topresists beträgt etwa 320 nm. Anschließend wird der Resist mittels eines Elektronenstrahlschreibers (Kombination von Rasterelektronenmikroskop 840A / Jeol und Elektronenstrahlschreiber Nanobeam / Sietec) bei einer Beschleunigungsspannung von ca. 30 kV mit Elektronen bestrahlt und danach auf einer Heizplatte 120 s bei ca. 110°C ausgeheizt (PEB). Dabei werden, katalysiert durch die photolytisch gebildete Säure, die tert.-Butylestergruppen abgespalten. Durch Entwickeln (30 s, Lackschleuder / Convac) mit einem wäßrig-alkalischen Entwickler (NMD-W 1,19 % / Tokyo Ohka, mit einem Zusatz von 1 % Methylbenzylamin) wird die geschriebene Struktur erhalten.

Durch das Elektronenstrahlschreiben werden zehn identische Linien/Gräben-Muster (1:1) mit einer Dosisstaffel beschrieben. Aus einer Auftragung der nach der Entwicklung gemessenen Linienbreiten in den einzelnen Strukturmustern gegen die entsprechende Schreibdosis läßt sich die Dp(0)-Dosis des Resists ermitteln: << 3 µC/cm². Der Resist wurde bei der technisch minimal möglichen Schreibdosis des Elektronenstrahlschreibers (Nanobeam) von 3 µC/cm² stark überbelichtet. Daraus ergibt sich, daß die Belichtungsempfindlichkeit des Resists deutlich unter 3 µC/cm² liegt.

Zur Übertragung der Struktur auf das Substrat wird der Topresist - nach der Naßentwicklung - 60 s mit einer Silylierungslösung behandelt, die 2 % eines Diaminopropyl-dimethylsiloxan-oligomers, 25 % Ethanol, 70 % Isopropanol und 3 % Wasser enthält. Anschließend wird 60 s in einem Sauerstoffplasma (900 W, 30 sccm O₂) trocken geätzt.

### Beispiel 3

Es wird ein Resist folgender Zusammensetzung verwendet: 6,4 MT eines Quaterpolymers aus Methacrylsäure-tert.-butylester, Maleinsäureanhydrid , Trimethylallylsilan und Methacrylsäureethoxyethylester (hergestellt durch radikalische Polymerisation), 0,8 MT des Esters von N-Hydroxyphthalimid mit p-Jodbenzolsulfonsäure (als Photosäurebildner), 0,8 MT 9-Hydroxy-9-fluorencarbonsäure (als Sensibilisator) und 92 MT 1-Methoxy-2-propyl-acetat (als Lösemittel). Der Resist wird auf eine Siliziumscheibe aufgeschleudert (Umdrehungszahl: 3000 min⁻¹, Dauer: 20 s), welche mit einer 0,5 µm dicken ausgeheizten Novolakschicht (220°C/45 min im Umluftofen) als Bottomresist versehen ist; dann wird auf einer Heizplatte getrocknet (140°C/60 s). Die Schichtdicke des dabei erhaltenen Topresists beträgt etwa 190 nm. Anschließend wird der Resist mittels eines Elektronenstrahlschreibers (HL 700 / Hitachi) bei einer Beschleunigungsspannung von ca. 30 kV mit Elektronen bestrahlt und danach auf einer Heizplatte 120 s bei ca. 110°C ausgeheizt (PEB). Dabei werden, katalysiert durch die photolytisch gebildete Säure, die tert.-Butylestergruppen abgespalten. Durch Entwickeln (60 s, Puddle-Anlage / Hamatech) mit einem wäßrig-alkalischen Entwickler (NMD-W 1,19 % / Tokyo Ohka, mit einem Zusatz von 1 % Methylbenzylamin) wird die geschriebene Struktur erhalten. Nach der Naßentwicklung wird der Topresist zweimal, jeweils 65 s, mit einer Silylierungslösung in Form einer 0,75 %igen Lösung eines Diaminopropyl-dimethylsiloxan-oligomers in einem Gemisch aus Isopropanol und Wasser (Volumenverhältnis 5:1) behandelt. Anschließend wird 60 s in einem Sauerstoffplasma (900 W, 30 sccm O₂) trocken geätzt.

Bei dieser Vorgehensweise werden - bei einer Bestrahlungsdosis von 0,9 µC/cm² - sehr gute Linien/Gräben-Teststrukturen mit einer Dimension von 0,15 µm erhalten.

## Patentansprüche

1. Chemisch verstärkter Resist für die Elektronenstrahl-Lithographie, enthaltend
- ein Polymer mit säurekatalysiert spaltbaren, lösungsinhibierenden Gruppen.
- eine photoreaktive Verbindung, die bei Elektronenbestrahlung eine Sulfonsäure mit einem pKₐ-Wert < 2,5 freisetzt (Photosäurebildner),
- einen elektronenstrahlempfindlichen Sensibilisator und
- ein Lösemittel,
**dadurch gekennzeichnet, daß** der Sensibilisator eine Verbindung folgender Struktur ist: 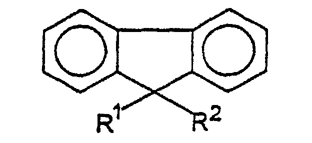 wobei folgendes gilt: R¹ = OH oder OR; R² = COOH oder COOR; mit R = C₁ bis C₅-Alkyl.

2. Resist nach Anspruch 1, **dadurch gekennzeichnet, daß** das Polymer tert.-Butylester- oder tert.-Butoxycarbonyloxygruppen aufweist.

3. Resist nach Anspruch 1 oder 2, **dadurch gekennzeichnet, daß** die Sulfonsäure eine pKₐ-Wert > -1 besitzt.

4. Resist nach einem der Ansprüche 1 bis 3, **dadurch gekennzeichnet, daß** der Photosäurebildner ein Diphenyliodoniumsalz, ein Triphenylsulfoniumsalz, ein Bisbenzoldisulfon oder ein N-Sulfonyloxy-maleinimid, -phtalimid oder -naphthalimid ist.

5. Resist nach einem der Ansprüche 1 bis 4, **dadurch gekennzeichnet, daß** der Sensibilisator 9-Hydroxy-9-fluorencarbonsäure ist.

6. Resist nach einem oder mehreren der Ansprüche 1 bis 5, **dadurch gekennzeichnet, daß** das Masseverhältnis von Photosäurebildner zu Sensibilisator 0,5:1 bis 1,5:1 beträgt, insbesondere etwa 1:1.

7. Resist nach einem oder mehreren der Ansprüche 1 bis 6, **dadurch gekennzeichnet, daß** das Lösemittel Methoxypropylacetat oder ein Gemisch aus γ-Butyrolacton und Cyclohexanon ist.

8. Verfahren zur Strukturierung von Resists, wobei auf einem Substrat eine Resistschicht aus einem Resist nach einem der Ansprüche 1 bis 7 aufgebracht wird, die Resistschicht getrocknet und mit Elektronen bestrahlt wird, und die elektronenstrahlexponierte Schicht einer Temperaturbehandlung unterworfen und anschlieβend nass entwickelt wird.

9. Verfahren nach Anspruch 8, wobei auf dem Substrat zunächst ein Bottomresist und darauf die Resistschicht aufgebracht wird.

10. Verfahren nach Anspruch 8 oder 9, wobei die Bestrahlung mit Elektronen mit einer Beschleunigungsspannung im Bereich von 0,5 bis 100 kV erfolgt.

## Claims

1. Chemically amplified resist for electron beam lithography, containing
- a polymer with dissolution-inhibiting groups that can be cleaved with acid catalysis,
- a photoreactive compound which upon electron irradiation releases a sulphonic acid with a pKₐ value of < 2.5 (photoacid generator),
- an electron-beam-sensitive sensitizer and
- a solvent,
**characterized in that** the sensitizer is a compound of the following structure: 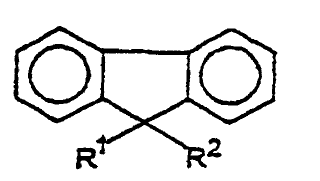 in which R¹ = OH or OR; R² = COOH or COOR; where R = C₁ to C₅ alkyl.

2. Resist according to Claim 1, **characterized in that** the polymer has tert-butyl ester or tert-butoxycarbonyloxy groups.

3. Resist according to Claim 1 or 2, **characterized in that** the sulphonic acid has a pKₐ value of > -1.

4. Resist according to one of Claims 1 to 3, **characterized in that** the photoacid generator is a diphenyliodonium salt, a triphenyl sulphonium salt, a bi-benzene disulphone, an N-sulphonyloxymaleimide, an N-sulphonyloxyphthalimide, or an N-sulphonyloxynaphthalimide.

5. Resist according to one of Claims 1 to 4, **characterized in that** the sensitizer is 9-hydroxy-9-fluorenecarboxylic acid.

6. Resist according to one or more of Claims 1 to 5, **characterized in that** the mass ratio of photoacid generator to sensitizer is 0.5:1 to 1.5:1, in particular about 1:1.

7. Resist according to one or more of Claims 1 to 6. **characterized in that** the solvent is methoxypropylacetate or a mixture of γ-butyrolactone and cyclohexanone.

8. Process for patterning resists, in which a film of a resist according to one of Claims 1 to 7 is applied to a substrate, the resist film is dried and irradiated with electrons, and the film exposed to electron beams is subjected to a temperature treatment and then to wet development.

9. Process according to Claim 8, in which first a bottom resist and then the resist film is applied to the substrate.

10. Process according to Claim 8 or 9, in which the irradiation with electrons takes place with an acceleration voltage in the range form 0.5 to 100 kV.

## Revendications

1. Photoréserve chimiquement amplifiée pour la lithographie par faisceau d'électrons, comprenant
- un polymère ayant des groupes inhibant la mise en solution et pouvant être séparés par catalyse acide,
- un composé photoréactif qui, par exposition à des électrons, dégage un acide sulfonique ayant un pKₐ < 2,5 (agent photoacidulant),
- un sensibilisateur sensible à un faisceau d'électrons et
- un solvant
**caractérisée en ce que** le sensibilisateur est un composé ayant la structure suivante : 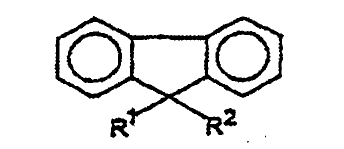 dans laquelle : R¹ = OH ou OR ; R² = COOH ou COOR ; avec R = alcoyle ayant de 1 à 5 atomes de carbone.

2. Photoréserve suivant la revendication 1, **caractérisée en ce que** le polymère a des groupes ester butylique tertiaire ou des groupes tert-butoxy-carbonyloxy.

3. Photoréserve suivant la revendication 1 ou 2, **caractérisée en ce que** l'acide sulfonique a un pKₐ>-1.

4. Photoréserve suivant l'une des revendications 1 à 3, **caractérisée en ce que** l'agent photoacidulant est un sel de diphényliodonium, un sel de triphénylsulfonium, une bis-benzodisulfone ou un N-sulfonyloxymaléinimide, un N-sulfonyloxy-phtalimide ou un N-sulfonyloxy-naphtalimide.

5. Photoréserve suivant l'une des revendications 1 à 4, **caractérisée en ce que** le sensibilisateur est l'acide 9-hydroxy-9-fluorènecarboxylique.

6. Photoréserve suivant l'une ou plusieurs des revendications 1 à 5, **caractérisée en ce que** le rapport en poids de l'agent photoacidulant au sensibilisateur est compris entre 0,5:1 et 1,5:1, et notamment d'environ 1:1.

7. Photoréserve suivant l'une ou plusieurs des revendications 1 à 6, **caractérisée en ce que** le solvant est de l'acétate de méthoxypropyle ou un mélange de γ-butyrolactone et de cyclohexanone.

8. Procédé de structuration de photoréserves, dans lequel on dépose sur un substrat une couche de photoréserve constituée d'une photoréserve suivant l'une des revendications 1 à 7, on sèche la couche de photoréserve et on l'expose à des électrons, et on soumet la couche ayant subi l'exposition au faisceau d'électrons à un traitement thermique et ensuite on la développe en voie humide.

9. Procédé suivant la revendication 8, dans lequel on dépose sur le substrat d'abord une photoréserve de fond et dessus la couche de photoréserve.

10. Procédé suivant la revendication 8 ou 9, dans lequel on effectue l'exposition aux électrons à une tension d'accélération de l'ordre de 0,5 à 100 kV.
